# EUROPEAN PATENT APPLICATION

(11) **EP 2 180 593 A1**
(43) Date of publication of application: **28.04.2010**
(21) Application number: 08167383.2
(22) Date of filing: 23.10.2008
(51) Int. Cl.: H03D 7/16

(54) **Frequency drift compensation for a frequency synthesizer**

(71) Applicant: STMicroelectronics Belgium N.V., 1930 Zaventem (BE); Semiconductor Ideas to The Market (ItoM) BV, 4839 AH Breda (NL)
(72) Inventor: Terryn, Steven, 9470 Denderleeuw (BE); Borremans, Marc, 3060 Korbeek-Dijle (BE); Goetschalckx, Paul, 2860 St. Katelijne Waver (BE)
(74) Representative: Bird, William Edward

(57) **Abstract**

Methods and devices for the compensation for variations in the frequency drift of a free-running VCO/DCO (voltage/digital controlled oscillator), e.g. inside a frequency synthesizer, are described. In one aspect, the frequency drift of the high-frequency synthesizer is compensated by adjusting the frequency of the baseband signal.

A counter unit is used to determine the frequency offset between the frequency of the free-running oscillator and a reference clock. A difference signal is used to correct the upstream or downstream signal.

## Description

### FIELD OF THE INVENTION

The present invention generally relates to radio frequency communication devices such as radio receivers and transmitters especially radio receivers, transmitters or transceivers having a mixer and a frequency synthesizer, as well as to a method of operating and making such a communication device, receiver, transmitter or transceiver.

### BACKGROUND OF THE INVENTION

Modem digital communications systems require significant digital signal processing and sophisticated analog and digital circuitry. A telecommunication transmitter or receiver has several basic stages to take a communication signal from the bitstream to the physical channel and back again. Communications signals require several stages of signal processing, both in the digital domain and analog domain.

In an IQ-Based RF transmitter, digital signal processing (DSP) circuits (e.g. chips) perform modulation, interpolation, and pulse-shaped filtering to a digital baseband signal. Because the signal processing is performed digitally, errors are typically small. However, once the communications signal is implemented in the analog domain with a digital-to-analog converter, it is subject to many sources of analog errors. Hence, the translation of a digital message signal into digitally upconverted I and Q signals can be performed with little or no error. However, once digital baseband signals enter the analog domain through digital-to-analog conversion, they are prone to a variety of sources of error such as frequency response of the digital-to-analog converter (DAC), baseband synchronization (quadrature skew), IQ gain imbalance, and, of particular importance, phase noise. Typical approaches to upconversion and downconversion are direct upconversion (zero IF), and heterodyne (intermediate frequency) upconversion.

For an IF transmitter the baseband I and Q signals first undergo direct upconversion to an intermediate frequency. They are then mixed with an addition local oscillator to reach the RF frequency. Typical IF upconverters use digital upconversion to the IF occurs in a DSP or FPGA. The IF waveform is then generated by a single digital-to-analog converter (DAC) before being upconverted to the RF signal. The local oscillator (LO) for a single-stage IF upconverter should be at the frequency difference of the RF carrier and the intermediate frequency.

In a heterodyne receiver the inverse procedure is carried out and the down-conversion to baseband I & Q channels is done at the intermediate-Frequency (IF).

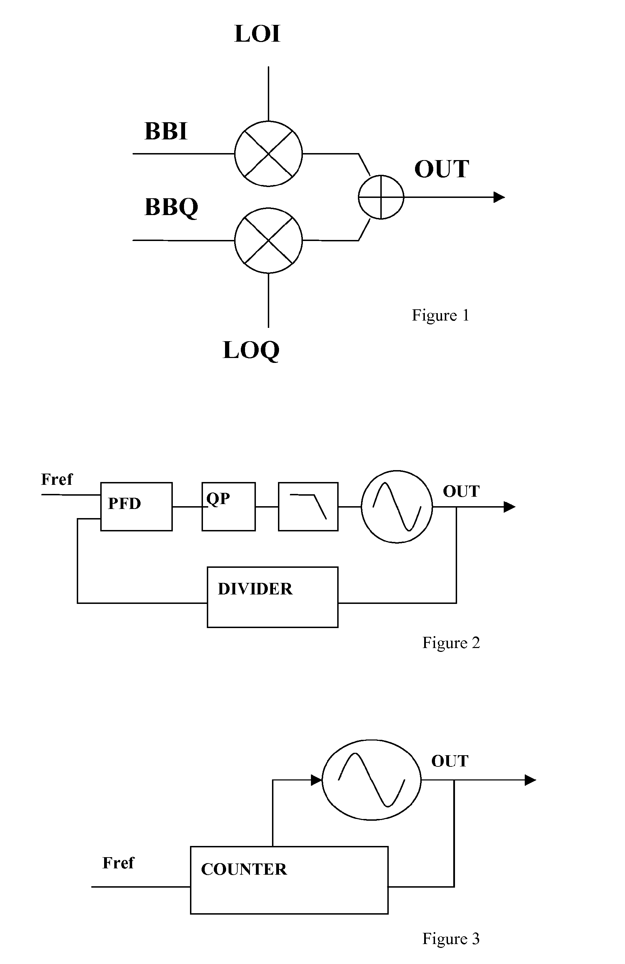

In many such applications, the output signal of a voltage controlled oscillator VCO or a digitally controlled (NC) oscillator DCO is used to mix a low-frequency signal up to a desired high frequency (transmitter) or vice versa (receiver) as for example in the IQ-transmitter or receiver as shown in Fig. 1. The frequency of such an oscillator is determined by its input voltage (e.g. in a VCO) or a digital control word (e.g. in a DCO).

Due to variations, e.g. in temperature and/or supply voltage over time, the output frequency will change. One solution is the usage of a PLL (Phase Locked Loop), which uses a number of additional circuits (e.g. divider, phase-frequency detector, charge pump, loop filter) to form a closed loop around the VCO/DCO to 'lock' the frequency (and phase) of the output signal to that of a reference clock signal by means of this feedback loop (Fig. 2). A VCO PLL typically includes a phase detector, a lowpass filter (LPF), a voltage controlled oscillator (VCO), and a feedback path. The phase detector serves as an error amplifier in the feedback loop. Based on an error signal produced by the phase detector, the PLL outputs a locked signal by reducing any phase difference between the input reference signal and the feedback signal.

One of the drawbacks of this solution is that it costs additional circuitry hence, requiring extra area, power consumption, design effort and risk to form this loop. Another disadvantage is that this additional circuitry also contributes to the (phase) noise at the output, which might be disadvantageous in some applications.

Another known solution is a VCO/DCO used in an open-loop configuration (Fig. 3). This is useful for slotted applications, where the frequency drift is limited, because the time during which the frequency can drift is also limited. In case of non-slotted applications, the frequency drift needs to be measured (e.g. by means of a counter) and compensated from time to time by an adjustment of the control input (voltage/digital control word). For example, a phase-locked loop can be configured for open-loop direct VCO modulation wherein the phase-locked loop, in a closed-loop state, phase-locks the voltage- controlled oscillator's output signal to a predetermined frequency reference (or a predetermined multiple of a predetermined frequency reference) and holds that multiple reference signal. The loop is opened, on a timely basis, for modulation of the voltage-controlled oscillator by the data signal. Components of the phase-locked loop, other than the voltage-controlled oscillator, are disabled when the loop is open (whereby power is saved). The voltage-controlled oscillator preferably comprises a first varactor for the locking to the reference signal and a second varactor for the direct modulation thereof by the data signal.
In addition, radio frequency (RF) receiver circuitry is configured for receiving an input data modulated signal. In the closed-loop state, the phase-locked loop phase-locks the voltage-controlled oscillator to provide a predetermined frequency reference signal. In an opened-loop state the voltage-controlled oscillator is injection-locked by the input data modulated signal.

A drawback of this solution is that every time a frequency adjustment is made (e.g. by changing control voltage or control word), this happens in an abrupt way. It thus creates a transient behaviour in the transmitter or receiver chain that is not very well under control and which can cause performance degradation at the instant of change in some applications.

It is also known to use a free-running oscillator. For example, EP 1304799 discloses a transmit chain and a receiver chain that use two mixers, a first one that has the output of a free running oscillator as an input and a second one that compensates for the difference between the free running oscillator frequency and the reference frequency. This known circuit suffers from the drawback that transmitter frequency offset cannot be distinguished from free running oscillator offset. For example, in the case of a moving transceiver, the Doppler effect will give an apparent change in the received frequency. This will be incorrectly diagnosed by the circuit as a different offset of the free running oscillator.

### Summary of the invention

An object of the present invention is to provide communication devices such as receivers and transmitters or transceivers having a mixer and a frequency synthesizer, as well as a method of operating and making such a communication device, receiver, transmitter or transceiver.

The present invention provides a method of compensating for frequency drift in a communication device having a unit for mixing an input signal with a free-running LO signal to produce an RF signal, the method comprising:
(a) receiving the input signal and mixing the input signal with a free-running LO signal to produce an RF signal,
(b) deriving from the LO signal an estimate of a frequency offset in the LO signal; and
(c) pre-correcting the frequency of the input signal that is to be mixed with the free running LO signal, thereby producing a corrected RF signal after mixing.
   The method can also include:
(d) frequency pre-correcting an initial upstream signal with the estimated frequency offset, thereby generating a pre-corrected upstream signal; and
(e) mixing the frequency pre-corrected upstream signal with the free-running LO signal to produce an upstream signal such that the upstream signal is free of the frequency offset to the extent the estimated frequency offset represents the undesired frequency offset.

The present invention also provides a method of compensating for frequency drift in a communication device having a unit for mixing an input signal with a free-running LO signal to produce a baseband signal, the method comprising:
(a) receiving the input signal and mixing the input signal with a free-running LO signal to produce a baseband signal,
(b) deriving from the LO signal an estimate of a frequency offset in the LO signal; and
(c) post-correcting the frequency of the baseband signal digitally thereby producing a corrected baseband signal.
   The method can also include:
(d) mixing a downstream signal with the free-running LO signal to produce the baseband signal,
(e) post-correcting the baseband signal with the estimated frequency offset, thereby generating a post-corrected baseband signal such that the baseband signal is free of the FO to the extent the estimated FO represents the undesired FO.

Embodiments of the present invention compensate for the frequency drift of the VCO/DCO (voltage/digital controlled oscillator), e.g. inside a frequency synthesizer. An aspect of the present invention is to compensate for the frequency drift of the highfrequency synthesizer by adjusting the frequency of the baseband signal accordingly.

### Brief Description of the Drawings

Figure 1 shows a known mixer unit;
Figure 2 shows a known PLL circuit;
Figure 3 shows a known open circuit PLL circuit;
Figure 4 shows a mixer arrangement according to an embodiment of the present invention;
Figure 5 shows another mixer arrangement according to an embodiment of the present invention;
Figure 6 shows another frequency correction arrangement according to an embodiment of the present invention;
Figure 7 shows another mixer arrangement according to another embodiment of the present invention;
Figure 8 shows another frequency correction arrangement according to another embodiment of the present invention;
Figure 9 shows a transmitter according to an embodiment of the present invention;
Figure 10 shows a receiver according to an embodiment of the present invention;
Figure 11 shows another mixer arrangement according to another embodiment of the present invention;
Figure 12 shows a counter unit according to an embodiment of the present invention.

### Description of the illustrative embodiments

Preferred embodiments of the present invention will now be described in detail with reference to the annexed drawings. In the following description, a detailed description of known functions and configurations incorporated herein has been omitted for conciseness.

Although, the present invention will be described with respect to particular embodiments and with reference to certain drawings, the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. Similarly, it is to be noticed that the term "connected", also used in the claims, should not be interpreted as being restricted to direct connections only, although "connected" includes a direct connection which may be advantageous. The term "coupling" should also be interpreted as not being limited to direct connections. Reference throughout this specification to "one embodiment" or "an embodiment" means that a particular feature, structure or characteristic described in connection with the embodiment is included in at least one embodiment of the present invention. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. Furthermore, while some embodiments described herein include some but not other features included in other embodiments, combinations of features of different embodiments are meant to be within the scope of the invention, and form different embodiments, as would be understood by those in the art. In the description provided herein, numerous specific details are set forth. However, it is understood that embodiments of the invention may be practised without these specific details. In other instances, well-known methods, structures and techniques have not been shown in detail in order not to obscure an understanding of this description.

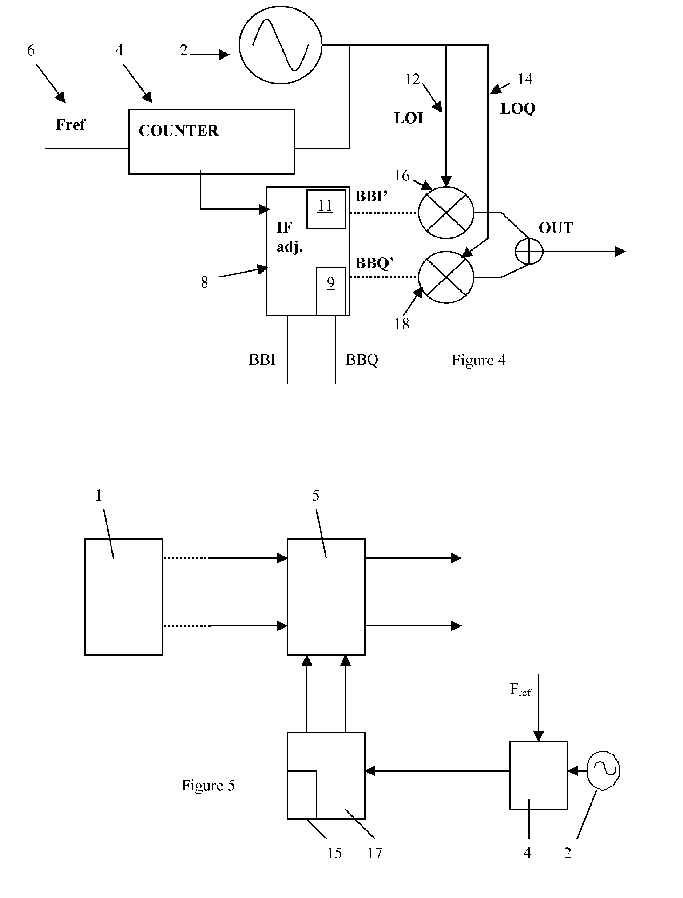

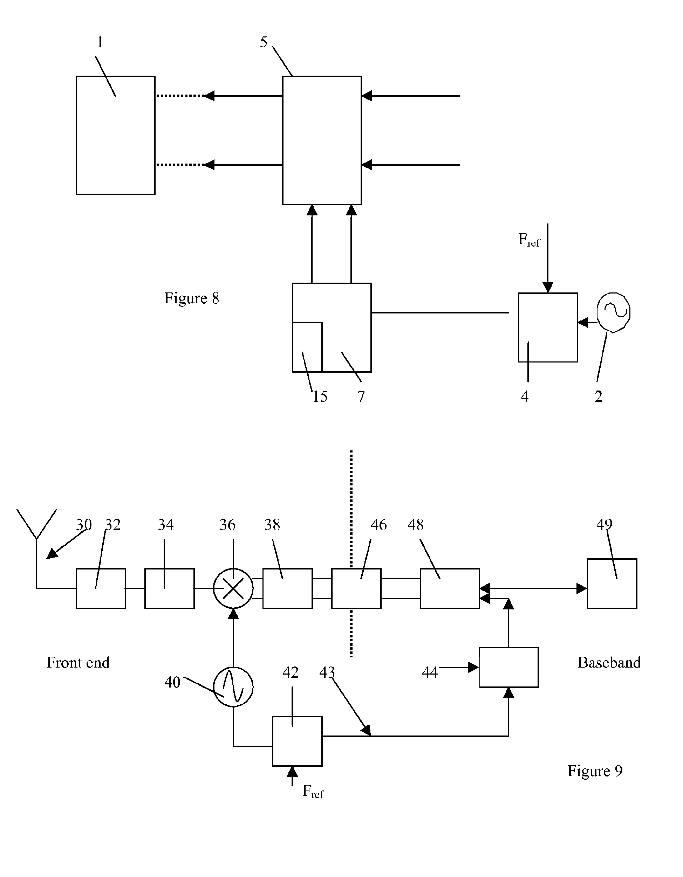

Fig. 4 is a schematic representation of basic parts of a transmitter for a telecommunications device, e.g. a radio frequency wireless device in accordance with an embodiment of the present invention. This figure only shows essential parts for explaining the invention, other features are missed out for clarity purposes. It should be understood that Figure 4 shows mixers 16, 18 which can be used in a transmitter in accordance with an embodiment of the present invention and that other components of a transmitter such as disclosed in Fig. 9 may be included with the components shown in Fig. 4 in order to obtain a fully functioning transmitter.

Fig. 4 shows a mixer compensation arrangement for a free-running oscillator 2, e.g. a VCO/DCO, in accordance with an embodiment of the present invention. A VCO/DCO can be set to a certain frequency however the frequency can drift over time. The oscillator 2 outputs two signals 12, 14 in quadrature, LOI, and LOQ, to two mixers 16, 18, respectively. A counter unit 4 receives an output from the free-running oscillator 2 as well as a reference frequency F_{ref} 6, e.g. from a clock such as a quartz clock. The counter unit 4 determines a value related to a difference between the frequency of the free running oscillator 2 and a desired frequency, i.e. it determines a value related to the frequency offset between the actual oscillator frequency and a desired or reference frequency, e.g. by counting the clock ticks and comparing. A signal representative of this difference (the difference signal) is fed to a pre-correcting circuit 8 for pre-correcting baseband signals BBI and BBQ with respect to the frequency offset and to output two frequency pre-corrected baseband signals in quadrature: BBI' and BBQ'. The baseband signals BBI and BBQ are digital signals and may be source coded, e.g. voice coded, modulated etc. Later on in the transmit chain these signals BBI' and BBQ' (or processed versions of these signals) are inputs to mixers 16, 18, e.g. in the analog or digital domain. The pre-correcting circuit 8 shifts the frequency of the baseband signals BBI and BBQ so that after later mixing in mixers 16, 18, signals with the correct frequency and phase are generated, i.e. the signals output from the mixers 16 and 18 have the required frequency, e.g. the required intermediate frequency or the required transmit frequency. No PLL has been used in this arrangement. Also a free running oscillator (FO) 2 is used. The free-running oscillator (FO) may be used over prolonged periods and there is no need to re-calibrate an open loop PLL or oscillator at regular intervals.

A way to generate these baseband signals BBQ', BBI' from the baseband signals BBQ, BBI, respectively, at a shifted frequency is to mix the baseband signals with a digital sine/cosine signals, e.g. programmable digitally generated sine/cosine signals or stored signals within the pre-correcting circuit 8. The mixing can be e.g. in a balanced mixer, but other ways are possible. By smoothly changing the frequency as a function of the input received from the VCO/DCO and the counter unit 4, the frequency drift is compensated as desired in a continuous manner. The smoothness of the frequency correction is determined by the bit depth of the digital components used, e.g. the LUT, comparators, counters. This bit depth can be selected easily hence allowing any granularity that is desired. Hence, an aspect of the present invention is continuous adaptive generation of output signals at a compensated frequency by selecting the appropriate adjustments according to an instantaneous phase of the input signal and a frequency difference signal. This flexibility to compensate for the frequency drift of the free running VCO/DCO in a certain, programmable, flexible way means that errors caused by such adaptation (if it would be done in another, more abrupt manner, for example), can be avoided. In this way, degradation of the signal quality by such uncontrolled transient behaviour is avoided.

The pre-correction circuit 8 may have a processor 11 and a memory 9. The processor 11 may be any suitable processor such as a microprocessor, e.g. an embedded microprocessor or may be a programmable logic device such as an FPGA. The memory 9 may be any suitable memory but is preferably non-volatile. Memory 9 can store digital representations of sine/cosine signals. The processor 11 may run suitable software or may be implemented as hardware to determine from the difference signal from the counter unit 4, the phase difference that must be applied to each digital signal of the baseband signals BBI and BBQ, in order to shift the frequency so that after pre-correction and mixing in mixers 16 and 18 the desired final reference frequency is obtained at the outputs of the mixers 16 and 18. The selected digital sine/cosine signals are multiplied with the digital signals BBI and BBQ in the pre-correction circuit 8. The digital sine/cosine signals may be stored in a look up table in the memory 9 and the processor 11 may be programmed, or hardware maybe implemented to interpolate between the discrete digital values of the sine/cosine signals in the memory 9 as required and depending upon the value of the difference signal from the counter unit 4.

A suitable pre-correcting circuit for amplitude modulated source signals, e.g. for use in the transmitter of Fig. 4, is shown in Fig. 5 in accordance with another embodiment of the present invention. The amplitude modulated baseband IQ signals BBI, BBQ derived from a modulator 1 are fed to a balanced mixer 5. The difference signal from the counter unit 4 is fed to a numerically controlled oscillator (NCO)7 that provides the difference signals for the I and Q signals to the balanced mixer 5 for mixing so that the frequency of the output baseband signals BBI' and BBQ' is compensated for the difference in frequency between the free running oscillator 2 and the reference frequency F_{ref}. The NCO 17 can store, for example, digital representations of sine/cosine signals, e.g. in a look up table 15. Suitable selection of difference signals in the form of digital representations of sine/cosine signals can be output and mixed in the balanced mixer 5 with the baseband BBI, BBQ signals to generate the compensated signals BBI' and BBQ'.

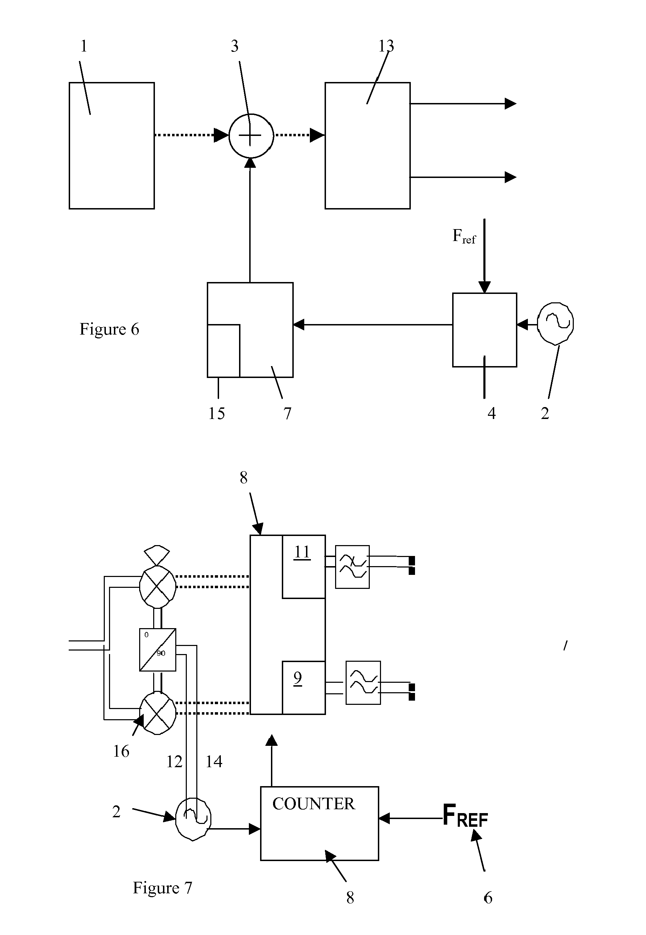

An alternative embodiment of the present invention for phase modulated baseband signals is shown in Fig. 6. A phase modulated source signal derived from a modulator 1 is fed to an adder 3. The pre-correction circuit 7 receives the difference signal from the counter unit 4 and outputs a phase change signal to the adder 3 which has such a value that the frequency of the signals entering the unit 13 for generating I & Q signals have been compensated for the difference in frequency between the free running oscillator 2 and the reference frequency F_{ref}. The unit 13 can store a digital representations in a sine/cosine lookup table and applies a selected representation depending on the phase of the signal it receives. The outputs of the unit 13 are the compensated I and Q signals. The phase change signals may be stored in a LUT 15. In this embodiment the signal entering unit 13 are precorrected for phase.

Fig. 7 shows a mixer compensation arrangement with a free-running oscillator 2, e.g. a VCO/DCO in a downstream path, i.e. in a receiver. The oscillator 2 outputs two signals 12, 14 in quadrature, to two mixers16, 18, respectively, located in the receive chain. Inputs to the mixers 16, 18 are signals, e.g. RF signals in quadrature. The input signals can be analog or digital signals. The output signals of the mixers 16, 18 are IQ signals that can be processed further in the receive chain. A counter unit 4 receives an output from the free-running oscillator 2 as well as a reference frequency Fref 6, e.g. from a clock such as a quartz clock. The counter unit 4 determines a value related to a difference between the frequency of the free running oscillator 2 and a desired frequency, i.e. it determines a value related to the frequency offset between the actual oscillator frequency and a desired or reference frequency, e.g. by counting the clock ticks and comparing. At some later point in the receive chain the IQ signals are supplied to a post-correcting circuit 8. A signal representative of the frequency difference between the FO frequency and the reference frequency F_{ref} (i.e. the difference signal) is fed to the post-correcting circuit 8 for post-correcting the received signals with respect to the frequency difference between the FO frequency and the reference frequency. The post-correcting circuit 8 shifts the frequency of these signals in a continuous, smooth way so that the output signals have the correct frequency and phase. The smoothness of the pre-correction is determined by the bit depth of the digital components used, e.g. the LUT, comparators, counters. This bit depth can be selected easily hence allowing any granularity that is desired. The output signals can be baseband signals. No PLL has been used in this arrangement. Also a free running oscillator 2 is used. The free-running oscillator may be used over prolonged periods and there is no need to re-calibrate an open loop PLL or oscillator at regular intervals.

A way to generate corrected baseband signals from the received baseband signals, respectively, at a shifted frequency is to mix the baseband signals with a digital sine/cosine signals, e.g. programmable digitally generated sine/cosine signals or stored signals within the post-correcting circuit 8 but other ways are possible. By smoothly changing the frequency as a function of the input received from the VCO/DCO and the counter unit 4, the frequency drift is compensated as desired. For example the post-correction circuit 8 may have a processor 11 and a memory 9. The processor 11 may be any suitable processor such as a microprocessor, e.g. an embedded microprocessor or may be a programmable logic device such as an FPGA. The memory 9 may be any suitable memory but is preferably non-volatile. Memory 9 can store digital representations of sine/cosine signals. The processor 11 may run suitable software or may be implemented as hardware to determine from the difference signal from the counter unit 4, the frequency difference that must be applied to each input signal, in order to shift the frequency so that after post-correction the desired final reference frequency is obtained at the outputs of the correction circuit 8. The selected digital sine/cosine signals are multiplied with the input signals in the post-correction circuit 8. The digital sine/cosine signals may be stored in a look up table in the memory 9 and the processor 11 may be programmed, or hardware maybe implemented to interpolate between the discrete digital values of the sine/cosine signals in the memory 9 as required and depending upon the value of the difference signal from the counter unit 4.

A suitable post-correcting circuit for amplitude modulated source signals in accordance with another embodiment of the present invention, e.g. for use in the receiver of Fig. 7, is shown in Fig. 8. Received amplitude modulated IQ signals are fed to a balanced mixer 5. The difference signal from the counter unit 4 is fed to a numerically controlled oscillator (NCO) 7 that provides the difference signals for the I and Q signals to the balanced mixer 5 for mixing so that the frequency of the output baseband signals to the modulator 1 is corrected for the difference in frequency between the free running oscillator 2 and the reference frequency F_{ref}. The NCO 7 can store digital representations of sine/cosine signals, e.g. in a look up table 15. Suitable selection of difference signals in the form of digital representations of sine/cosine signals can be output and mixed in the balanced mixer 5 with the input signals to generate the corrected output signals.

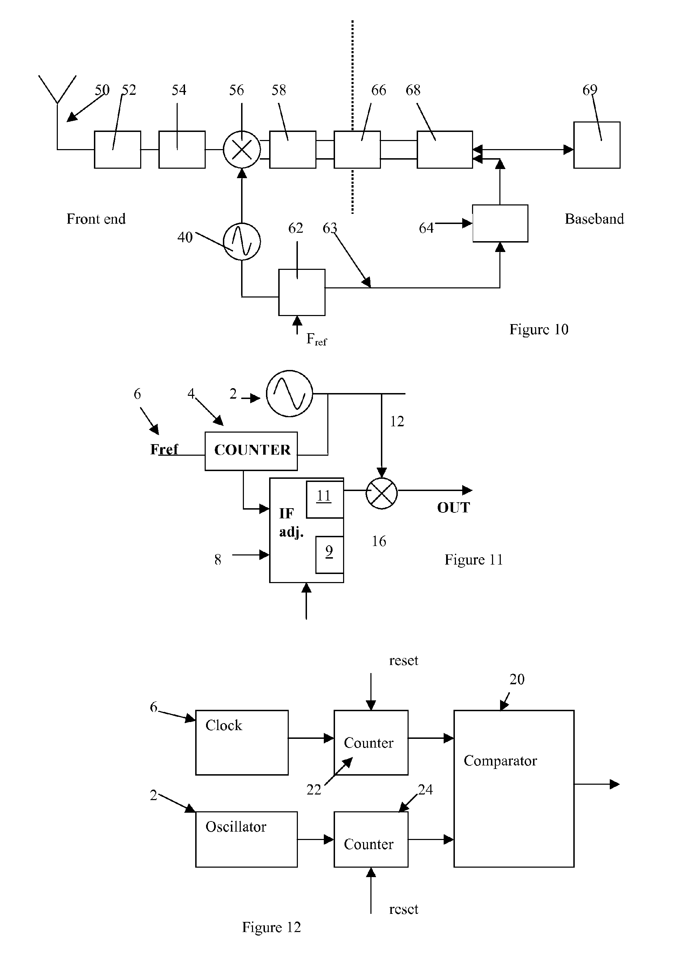

The present invention can be used in a transmitter alone, e.g. in a television transmitter with IF upconversion - see Fig. 9. The present invention can be used with a receiver alone, e.g. an FM radio using intermediate frequency downconversion - see Fig. 10. Alternatively, a radio transceiver has a transmit and receive path in a single device which can be used with the present invention. Such a transceiver can have an analog radio front end and a digital part separated by an analog to digital converter (ADC) - see Figs. 9 and 10. Certain components shown duplicated in Figs. 9 and 10 can be replaced with a single unit in a transceiver, e.g. the free running oscillator may be a single oscillator for the transmit and receive paths. Figs. 9 and 10 are examples only and are not limiting for the present invention.

In a transmitter (Fig. 9) according to an embodiment of the present invention, the radio front-end includes a radio upconversion device, e.g. comprising RF filters, a free running oscillator, and image-reject mixers to process input signals up to high frequencies. For example, a radio signal to be transmitted is supplied to an antenna 30 and this radio signal is the result of processing by a radio upconversion device including a transmission band-pass filter 32, a power amplifier 34 an analog up-mixer 36 and a low pass filter 38. In accordance with embodiments of the present invention the local oscillator is a free-running oscillator 40 (FO). The baseband source signal is processed in a unit 49 which can include a source coder, a modulator etc. Inputs for a mixer unit 48 are the modulated source signal and a signal from a compensation unit 44. An output of the mixer unit 48 is the I and Q signals which have been compensated so that the error between the frequency of the free running oscillator 40 and the reference frequency F_{ref} is compensated in the upmixer 36. In a DAC 46, the signal received from compensation unit 48 is converted to analog signals at the intermediate frequency. The baseband signal is shifted to a higher intermediate frequency.

The mixer unit 48 receives a frequency correction signal from the compensation unit 44. The compensation unit 44 receives a difference signal 43 from a counter unit 42. The counter unit 42 receives an input from the FO 40 and also from a frequency reference F_{ref}, e.g. an accurate clock. The output from the counter unit 42 is the difference signal 43 which has a value representative of the difference between the frequency of the FO 40 and the reference frequency F_{ref}. The difference signal 43 is fed continuously to the compensation unit 44 which updates continuously the frequency of the IQ signals output from the mixer unit 48. This compensation arrangement may be configured according to any of the embodiments of the present invention, e.g. according to any of the embodiments shown in Figs. 4 to 6.

In a receiver (Fig. 10) according to an embodiment of the present invention, the radio front-end includes a radio downconversion device, e.g. comprising RF filters 52, a free running oscillator 40, and image-reject mixers to process input signals at high frequencies. The input signal is shifted to a lower intermediate frequency which allows, for example, on-chip construction of low power filters. For example, a transmitted radio signal is received at an antenna 50 and is processed by the radio downconverison device including a reception band-pass filter 52, a linear amplifier 54 an analog down-mixer 56 and a complex band pass filter 58 used to obtain the bandpass signal centred on the intermediate frequency. In accordance with embodiments of the present invention the local oscillator 60 is a free-running oscillator. An optional Voltage Gain Adaptation (VGA) block can be used in order to adapt the signal amplitude to the input dynamic range of the other blocks in the device. In particular it is useful to control the amplitude so as not to overrange the A/D converter (ADC) 66. In the ADC 66, the signal received from the analog downconversion device is sampled with a sampling frequency F_{C}, and digitised. The signals are preferably oversampled in the ADC 66 as the sampling frequency is a higher than the baseband signal frequency. The ADC 66 supplies IQ signals to a mixer unit 68.

The mixer unit 68 receives a frequency correction signal from a compensation unit 64. The compensation unit 64 receives a difference signal 63 from a counter unit 62. The counter unit 62 receives an input from the FO 60 and also from a frequency reference F_{ref}, e.g. an accurate clock. The output from the counter unit 62 is the difference signal 63 which has a value representative of the difference between the frequency of the FO 60 and the reference frequency F_{ref}. The difference signal 63 is fed continuously to the compensation unit 64 which updates continuously the frequency of the signals output from the mixer unit 68 to the demodulator demodulator 69 so that the difference between the frequency of the FO 60 and the reference frequency F_{ref} is corrected. This compensation arrangement may be configured according to any of the embodiments of the present invention, e.g. according to any of the embodiments shown in Figs. 7 to 9.

Figure 11 shows another embodiment of the mixer arrangement 10 according to the present invention. In this case there is a single digital input signal - a bitstream of digital signals that can be source coded, e.g. voice coded and modulated. These are pre-corrected in the pre-correction circuit 8 depending on the difference signal from the counter unit 4. Other details are exactly the same as described for the embodiment of Fig. 4 except that only one digital bitstream is processed through the pre-correction circuit 8 and the single mixer 16.

A counter unit in accordance with an embodiment of the present invention is shown in Fig. 12. The outputs from a reference clock 6 and a free-running oscillator 2 are supplied to first and second counters 22, 24, respectively. The outputs from the counters are supplied to a comparator 20 which compares the two signals and outputs the difference signal to be supplied to the correction unit 8. The counters have a reset, e.g. the counters are reset each time that the first counter 22 counts a value indicative of the completion of one or more periods of the reference frequency.

Numerous other variations will also be apparent to one of ordinary skill in the art. It will therefore be appreciated by those of ordinary skill in the art that the invention can be embodied in other specific forms without departing from its spirit or essential character. The presently disclosed embodiments are therefore considered in all respects to be illustrative and not restrictive. The scope of the invention is indicated by the appended claims, and all changes which come within the meaning and range of equivalents thereof are intended to be embraced therein.

## Claims

1. A method of compensating for frequency drift in a communication device having a unit for mixing an input signal with a free-running LO signal to produce an RF signal, the method comprising:
(a) receiving the input signal and mixing the input signal with a free-running LO signal to produce an RF signal,
(b) deriving from the LO signal an estimate of a frequency offset in the LO signal by comparing the frequency of the LO signal with a reference signal from a reference clock; and
(c) pre-correcting the frequency of the input signal that is to be mixed with the free running LO signal, thereby producing a corrected RF signal after mixing.

2. The method according to claim 1, wherein the input signal is provided to a balanced mixer and the frequency pre-correcting includes inputting a correction signal to the balanced mixer.

3. The method according to 1, wherein the input signal is phase modulated and is provided to an adder, and the frequency pre-correcting includes inputting a phase correction signal to the adder, the output of the adder being supplied to a unit for generating quadrature signals.

4. A communication device having compensation for frequency drift, the communication device having a local oscillator LO, the communication device comprising:
a mixer for mixing an input signal with a free-running LO signal to produce an RF signal,
a reference clock,
means for deriving from the LO signal an estimate of a frequency offset in the LO signal by comparing the frequency of the LO signal with a reference signal from the reference clock; and
means for pre-correcting the frequency of the input signal that is to be mixed with the free running LO signal, the output of the mixer being a corrected RF signal.

5. The device according to claim 4, wherein the means for pre-correcting includes a balanced mixer, the input signal being provided to the balanced mixer, further comprising means for inputting a correction signal to the balanced mixer.

6. The device according to 4, wherein the input signal is phase modulated, and the means for pre-correcting includes an adder, and the frequency pre-correcting means has means for inputting a phase correction signal to the adder, the output of the adder being supplied to a unit for generating quadrature signals.

7. The device according to any of the claims 4 to 6 further comprising an analog front end and digital baseband unit, the mixer for mixing an input signal with the free-running LO signal to produce an RF signal being in the front end, and the means for pre-correcting the frequency of the input signal is located in the digital baseband unit.

8. A method of compensating for frequency drift in a communication device having a unit for mixing an RF input signal having an RF frequency with a free-running LO signal to produce an IF signal with a lower frequency than the RF frequency, the method comprising:
(a) receiving the input signal and mixing the input signal with a free-running LO signal to produce the IF signal,
(b) deriving from the LO signal an estimate of a frequency offset in the LO signal by comparing the frequency of the LO signal with a reference signal from a reference clock; and
(c) post-correcting the frequency of signal having a lower frequency than the RF frequency to thereby produce a corrected IF signal.

9. The method according to claim 8, wherein the input signal is provided to a balanced mixer and the frequency post-correcting includes inputting a correction signal to the balanced mixer.

10. A communication device, the device receiving an RF input signal having an RF frequency and mixing the RF signal with a free-running Local Oscillator (LO) signal including a frequency offset (FO), thereby producing an IF signal with a lower frequency than the RF frequency, comprising:
a mixer for mixing the RF signal with the free-running LO signal to produce an initial signal,
means for deriving from the LO signal an estimate of a frequency offset in the LO signal by comparing the frequency of the LO signal with a reference signal from a reference clock; and
a post-correction circuit adapted to remove the estimated FO from the initial signal to produce a corrected IF signal such that the corrected IF signal is free of the undesired FO to the extent the estimated FO represents the undesired FO.

11. The device according to claim 10, wherein the post-correcting circuit includes a balanced mixer, the initial signal being provided to the balanced mixer, further comprising means for inputting a correction signal to the balanced mixer.

12. The device according to any of the claims 10 or 11 further comprising an analog front end and digital baseband unit, the mixer for mixing an input signal with the free-running LO signal being in the front end, and the means for post-correcting the frequency of the input signal is located in the digital baseband unit.

13. The method according to claim 1 or 2 or 8 or 9 or the device of claim 4 or 5 or 10 or 11, wherein the input signal is amplitude or phase modulated.

14. The method of any of claims 1 or 2 or 8 or 9, wherein estimating the frequency offset includes counting a frequency of the LO signal and of the reference clock signal; and comparing the counted frequencies and producing a signal representative of the estimated frequency offset.

15. The device according to any of the claims 4 to 7 or 10 to 12, wherein the means for estimating the frequency offset includes a counter unit for counting a frequency of the LO signal and of the reference clock signal; and
a comparator for comparing the counted frequencies and producing a signal representative of the estimated frequency offset.
